# FASCICULE DE BREVET EUROPEEN

(11) **EP 1 397 865 B1**
(45) Date de publication et mention de la délivrance du brevet: **30.03.2005**
(21) Numéro de dépôt: 02748959.0
(22) Date de dépôt: 18.06.2002
(51) Int. Cl.: H03L 7/26

(54) **DISPOSITIF DE FOURNITURE D'UN SIGNAL DE FREQUENCE ETALON**
ANORDNUNG ZUR ERZEUGUNG EINES FREQUENZSTANDARDSIGNALS
DEVICE FOR PRODUCING A REFERENCE FREQUENCY SIGNAL

(30) Priorité: 18.06.2001 FR 0107982
(43) Date de publication de la demande: 17.03.2004
(73) Titulaire: CENTRE NATIONAL DE LA RECHERCHE SCIENTIFIQUE (CNRS), 75016 Paris (FR); CENTRE NATIONAL D'ETUDES SPATIALES, 75001 Paris (FR)
(72) Inventeur: BARILLET, Roland, F-91190 Gif-sur-Yvette (FR); AUDOIN, Claude, F-92290 Chatenay-Malabry (FR); HAMOUDA, Frédéric, F-91600 Savigny-sur-Orge (FR)
(74) Mandataire: Blot, Philippe Robert Emile
(86) Numéro de dépôt international: PCT/FR2002/002104
(87) Numéro de publication internationale: WO 2002/103913

(56) Documents cités:
- US-A- 5 148 122
- PATENT ABSTRACTS OF JAPAN vol. 1999, no. 12, 29 octobre 1999 (1999-10-29) -& JP 11 205138 A (NEC MIYAGI LTD;NEC CORP), 30 juillet 1999 (1999-07-30)
- BARILLET R ET AL: "LIMITATION OF THE CLOCK FREQUENCY STABILITY BY THE INTERROGATION FREQUENCY NOISE: EXPERIMENTAL RESULTS" IEEE TRANSACTIONS ON INSTRUMENTATION AND MEASUREMENT, IEEE INC. NEW YORK, US, vol. 42, no. 2, 1 avril 1993 (1993-04-01), pages 276-280, XP000387467 ISSN: 0018-9456
- KOGA Y ET AL: "A MICROWAVE EXCITER FOR CS FREQUENCY STANDARDS BASED ON A SAPPHIRE-LOADED CAVITY OSCILLATOR" IEEE TRANSACTIONS ON ULTRASONICS, FERROELECTRICS AND FREQUENCY CONTROL, IEEE INC. NEW.YORK, US, vol. 48, no. 1, janvier 2001 (2001-01), pages 1-5, XP001050962 ISSN: 0885-3010
- GUPTA A S ET AL: "Cs frequency synthesis: a new approach" PROCEEDINGS OF THE 1999 JOINT MEETING OF THE EUROPEAN FREQUENCY AND TIME FORUM AND THE IEEE INTERNATIONAL FREQUENCY CONTROL SYMPOSIUM, vol. 2, 1999, pages 615-619, XP010377731 cité dans la demande
- KARLQUIST R K: "A NEW RF ARCHITECTURE FOR CESIUM FREQUENCY STANDARDS" PROCEEDINGS OF THE FREQUENCY CONTROL SYMPOSIUM. HERSHEY, MAY 27 - 29, 1992, NEW YORK, IEEE, US, 27 mai 1992 (1992-05-27), pages 134-142, XP000341347 ISBN: 0-7803-0476-4 cité dans la demande

## Description

L'invention concerne un dispositif de fourniture d'un signal de fréquence étalon à partir de la réponse d'un résonateur atomique à un signal d'attaque qui lui est envoyé.

Les résonateurs atomiques, par exemple au césium, sont utilisés pour la précision de leur transition atomique, définissant une fréquence de référence exacte et très stable. Dans le dispositif prévu à cet effet, on synthétise un signal d'attaque ayant la fréquence de résonance du résonateur que l'on envoie modulé au résonateur, on recueille et on démodule le signal de réponse du résonateur et on asservit en fréquence un premier oscillateur au moyen du signal démodulé. Ces dispositifs permettent de générer un signal étalon ayant une grande exactitude et stabilité en fréquence de l'ordre de 10⁻¹² et 10⁻¹⁴ respectivement.

De tels dispositifs sont exigés par exemple dans des applications spatiales, la navigation par satellite.

Le document US-A-5 148 122 décrit un dispositif du genre mentionné ci-dessus, pour un résonateur au césium, comportant :
- un premier oscillateur à 10 MHz, apte à produire un premier signal de fréquence fonction du signal de réponse du résonateur;
- un deuxième oscillateur produisant un deuxième signal à 640 MHz en fonction d'un signal de commande ;
- des moyens d'asservissement en phase du deuxième signal sur le premier signal, produisant le signal de commande;
- des moyens de génération du signal étalon et du signal d'attaque en aval du deuxième oscillateur, lesquels comportent des diviseurs et multiplieurs de fréquence.

Ce dispositif s'avère présenter des inconvénients. Il nécessite un grand nombre d'éléments constitutifs, ce qui le rend complexe, lourd et volumineux. Il consomme une grande quantité d'énergie et est coûteux. Le document Patent Abstracts of Japan, vol. 1999, no. 12, 29 octobre 1999 & JP 11 205 138 A (NEC MIYAGI Ltd.), 30 juillet 1999, décrit un dispositif tel que décrit dans le préambule de la revendication 1.

Le document 1992 IEEE Frequency Control Symposium, "a new RF architecture for cesium frequency standards", pages 134 à 142, prévoit un dispositif similaire, comportant en plus un troisième oscillateur en aval des circuits multiplieurs et diviseurs et produisant le signal d'attaque à la fréquence de résonance.

D'une plus grande complexité, ce dispositif crée en plus des perturbations par rayonnement electromagnétique, auxquelles le résonateur atomique est sensible, du fait de l'utilisation d'un oscillateur à la fréquence de résonance de celui-ci. La neutralisation de ces perturbations nécessite des blindages, ce qui est coûteux, lourd et volumineux.

Le document 1999 Joint Meeting EFTF - IEEE IFCS, "Cs Frequency synthesis : a new approach", volume 2, pages 615 à 619, décrit un synthétiseur de fréquence de résonateur au césium comportant des oscillateurs à 5 MHz, 100 MHz et 6,4 GHz. Un diviseur régénératif analogique génère à partir de l'oscillateur à 6.4 GHz des signaux à 3,2 GHz et à 9,6 GHz. Un signal à 9,192 GHz pour le résonateur au césium est généré après mélange d'un signal à 407,368 MHz au signal à 9,6 GHz.

Ce synthétiseur comporte également un grand nombre de circuits, dont un diviseur régénératif analogique devant être fabriqué spécialement pour ce synthétiseur.

L'invention vise à obtenir un dispositif palliant les inconvénients de l'état de la technique, qui soit de structure simple ne comportant que des circuits classiques du commerce et ce en relativement petit nombre.

A cet effet, l'invention prévoit un dispositif de fourniture d'un signal de fréquence étalon à partir de la réponse d'un résonateur atomique à un signal d'attaque qui lui est envoyé, comportant :
- un premier oscillateur apte à produire un premier signal de fréquence fonction du signal de réponse du résonateur;
- un deuxième oscillateur apte à produire un deuxième signal de fréquence égale à un multiple entier de celle du premier signal, en fonction d'un signal de commande ;
- des moyens d'asservissement en phase du deuxième signal sur le premier signal, produisant le signal de commande;
- des moyens de génération du signal d'attaque à partir du deuxième signal;
caractérisé en ce qu'il comprend des moyens de fourniture directe d'au moins un signal étalon à partir du premier signal, connectés en aval du premier oscillateur et en amont du deuxième oscillateur et le deuxième oscillateur est choisi de manière à produire un deuxième signal de fréquence égale à une valeur comprise dans une plage de 1 GHz de part et d'autre de la fréquence de résonance du résonateur.

Grâce à l'invention, on fait l'économie de circuits multiplieurs et diviseurs de fréquence en aval du deuxième oscillateur pour générer le signal étalon et le signal d'attaque.

Suivant une caractéristique de l'invention, le deuxième oscillateur est choisi de manière à produire un deuxième signal de fréquence sensiblement égale à un des vingt multiples entiers de la fréquence du premier signal, les plus proches de la fréquence de résonance du résonateur.

Suivant d'autres caractéristiques de l'invention, permettant de simplifier davantage la structure du dispositif :
- le deuxième oscillateur est choisi de manière à produire un deuxième signal de fréquence comprise dans une plage de 50 MHz de part et d'autre de la fréquence de résonance du résonateur ;
- le deuxième oscillateur est choisi de manière à produire un deuxième signal de fréquence sensiblement égale à un des deux multiples entiers de la fréquence du premier signal, les plus proches de la fréquence de résonance du résonateur.

Suivant une caractéristique, permettant d'obtenir une bonne cohérence de phase entre les premier et deuxième signaux, les moyens d'asservissement en phase comprennent un circuit diviseur logique de fréquence par le multiple entier du deuxième signal, un circuit comparateur de phase de la sortie du circuit diviseur du deuxième signal et du premier signal et un circuit de génération du signal de commande du deuxième oscillateur à partir du signal de sortie du circuit comparateur.

Suivant une autre caractéristique de l'invention, permettant à la fois de se dispenser de multiplieurs pour générer le signal d'attaque et d'éviter que le deuxième oscillateur ne perturbe le résonateur, le deuxième oscillateur est choisi de manière à produire un deuxième signal de fréquence décalée par rapport à la fréquence de résonance du résonateur, les moyens de génération comportant, en aval du deuxième oscillateur, un circuit apte à additionner et/ou soustraire en fréquence au deuxième signal un signal de décalage pour fournir le signal d'attaque, et un circuit de fourniture du signal de décalage. II est ainsi rendu possible d'ajuster la puissance du signal d'attaque, délivrée au résonateur par l'intermédiaire du circuit additionneur et/ou soustracteur de fréquence, pour délivrer la puissance juste nécessaire au résonateur. De plus, les éventuelles fluctuations de puissance du deuxième signal ne modifient pas sensiblement la puissance du signal d'attaque, qui peut être contrôlée proportionnellement par le circuit de décalage. On s'affranchit ainsi des problèmes de vieillissement du deuxième oscillateur.

Dans un mode de réalisation, le circuit additionneur et/ou soustracteur est constitué par un circuit mélangeur, par exemple à bande latérale unique.

Dans un mode de réalisation, le circuit de fourniture du signal de décalage comprend un synthétiseur numérique de fréquence synchronisé sur le premier signal.

Suivant une caractéristique de l'invention, les moyens de génération du signal d'attaque ne comportent, en aval du deuxième oscillateur, que des circuits d'addition et/ou de soustraction de fréquence au deuxième signal.

Dans un mode de réalisation de l'invention, approprié pour générer des signaux de fréquence étalon à partir de la réponse d'un résonateur atomique au césium, le deuxième oscillateur est apte à produire un deuxième signal de 9200 MHz et le premier oscillateur est apte à fournir un premier signal de 10 MHz.

Suivant une caractéristique de l'invention, le dispositif ne comporte, comme oscillateurs, que les premier et deuxième oscillateurs.

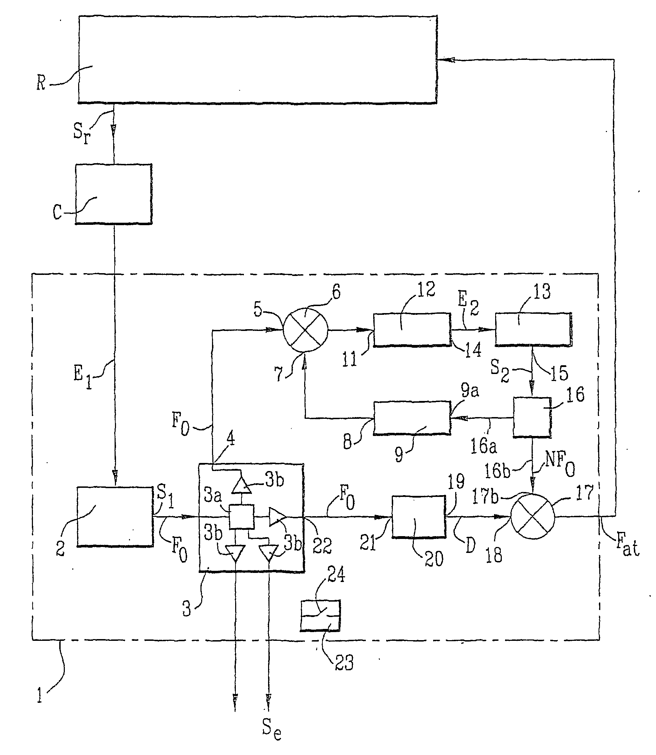

L'invention sera mieux comprise à la lumière de la description qui va suivre, faite en référence au dessin donné uniquement à titre d'exemple et représentant schématiquement un dispositif de fourniture de fréquence étalon selon l'invention.

Le dispositif 1 de fourniture de fréquence étalon est décrit en référence à un résonateur R au césium. Bien entendu, le dispositif peut également être utilisé avec tout autre résonateur atomique, par exemple avec un résonateur au rubidium.

Le dispositif 1 de fourniture de fréquence étalon comporte un premier oscillateur 2 produisant en sortie un premier signal S1 de fréquence déterminée F0, réglée par un signal de réglage reçu sur une entrée E1 de réglage. Le premier oscillateur 2 est par exemple de type VCXO, par exemple à 10MHz. L'entrée E1 de réglage est reliée à un circuit de contrôle C, qui délivre le signal de réglage en fonction du signal Sr de réponse du résonateur R. On se reportera, s'agissant du fonctionnement du résonateur R et du circuit de contrôle C au document US-A-5 148 122, où ces éléments sont désignés par les références 26 et 11 respectivement et la description est donnée colonne 3, ligne 47 à colonne 4, ligne 51.

La sortie du premier oscillateur 2 est reliée à un circuit 3 de distribution du premier signal S1 et de fourniture du signal étalon Se. Bien entendu, plusieurs signaux étalon peuvent être fournis par le circuit 3. Des signaux étalon de fréquence sous-multiple de celle du signal Se étalon à 10 MHz peuvent également être fournis par des circuits adéquats situés en aval du signal Se et du circuit 3 de fourniture. Le circuit 3 comporte un circuit 3a de répartition de puissance attaqué par le premier signal S1 et dont chaque sortie est connectée à un amplificateur 3b d'isolation à large bande et à faible gain fournissant en sortie un signal à la fréquence F0. Un ou plusieurs des amplificateurs 3b d'isolation fournit en sortie le signal étalon Se à la même fréquence F0. Une sortie 4 d'un autre amplificateur 3b d'isolation du circuit 3 de distribution et de fourniture est connectée à une première entrée 5 d'un comparateur 6 de phase, connecté par une deuxième entrée 7 à la sortie 8 d'un diviseur 9 logique de fréquence, large bande. La sortie 10 du comparateur de phase est reliée à l'entrée 11 d'un circuit 12 de génération du signal de commande d'un deuxième oscillateur 13 micro-onde. Le diviseur 9 de fréquence peut être réalisé en plusieurs étages diviseurs en cascade.

La sortie 14 du circuit 12 de génération pour le signal de commande est reliée à une entrée E2 de commande d'un deuxième oscillateur 13, produisant sur sa sortie 15 un deuxième signal S2 de fréquence déterminée, en fonction du signal présent sur son entrée E2 de commande. Le deuxième signal S2 possède une fréquence située à moins de 1 GHz au-dessus ou au-dessous de la fréquence de résonance du résonateur R. La fréquence du deuxième signal est égale à un multiple entier N de la fréquence F0 du premier signal S1. Le deuxième signal S2 est de fréquence proche et différente de la fréquence de résonance du résonateur R et est de fréquence égale à l'un des vingt multiples entiers de la fréquence du premier signal S1, les plus proches de la fréquence de résonance, et par exemple des deux multiples entiers de la fréquence du premier signal S1, les plus proches de la fréquence de résonance. Dans la réalisation représentée, la fréquence du deuxième signal S2 produit par le deuxième oscillateur est de 9200 MHz pour un résonateur au césium ayant une fréquence de résonance de 9 192 631 770 Hz.

La sortie 15 du deuxième oscillateur 13 est envoyée à un coupleur 16 relié par une première sortie 16a à l'entrée 9a du diviseur 9 de fréquence dont le rapport de division est égal au multiple entier N précité. Le signal présent sur la sortie 8 du diviseur 9 possède une fréquence fondamentale égale à la fréquence F0 du premier signal. Le circuit 12 de génération du signal de commande, le diviseur 9 et le comparateur 6 sont tels qu'ils forment un circuit de verrouillage de phase du deuxième signal S2 sur le premier signal S1.

Une deuxième sortie 16b du coupleur 16 est reliée à une première entrée 17b d'un circuit mélangeur 17 de fréquence, dont la deuxième entrée 18 reçoit un signal D de décalage de fréquence et dont la sortie fournit un signal Fat d'attaque du résonateur atomique R ayant sa fréquence de résonance. Le circuit mélangeur 17 réalise une addition et/ou une soustraction en fréquence du signal D de décalage au deuxième signal S2. Le signal D de décalage est modulé en fréquence par un signal très basse fréquence de par exemple quelques dizaines de Hertz et est produit à la sortie 19 d'un circuit 20 de fourniture. Dans l'exemple précité, le circuit 20 fournit un signal D de décalage de 7,368230 MHz. Le circuit 20 de fourniture est par exemple formé par un synthétiseur numérique direct basse fréquence de type DDS. Le circuit 20 de fourniture est synchronisé par son entrée 21 de synchronisation reliée. à une sortie 22 du circuit 3 de distribution.

Dans une réalisation permettant d'avoir un circuit moins coûteux, le circuit mélangeur 17 est à deux bandes latérales et fournit en sortie un signal somme de fréquences et un signal différence de fréquences à partir du deuxième signal S2 et du signal D de décalage, dans l'exemple précédent à 9207,368230 MHz et 9192,631770 MHz respectivement.

Dans une réalisation permettant de s'affranchir des effets parasites provoqués par le signal de sortie à 9207,368230 MHz et d'obtenir une meilleure exactitude et stabilité en fréquence, le circuit mélangeur 17 est à bande latérale unique sélectionnée pour conserver en sortie le signal Fat d'attaque à la fréquence de résonance et atténuer le signal à la fréquence de 9207,368230 MHz.

Le dispositif 1 comprend également une alimentation 23 en énergie électrique pour ses différents constituants. Le dispositif 1 peut être mis en marche directement par actionnement d'un interrupteur 24 prévu sur l'alimentation, sans réglage.

Les premier et deuxième oscillateurs 2 et 13 respectivement peuvent être choisis dans une version haute performance pour obtenir une exactitude et stabilité en fréquence de l'ordre de 10⁻¹² et 10⁻¹⁴ respectivement ou dans une version basse performance moins onéreuse pour obtenir des exactitude et stabilité de l'ordre de 10⁻¹¹ et 10⁻¹³ respectivement.

## Revendications

1. Dispositif (1) de fourniture d'un signal (Se) de fréquence étalon à partir de la réponse d'un résonateur (R) atomique à un signal (Fat) d'attaque qui lui est envoyé, comportant:
- un premier oscillateur (2) apte à produire un premier signal (S1) de fréquence (F0) fonction du signal (E1) de réponse du résonateur (R);
- un deuxième oscillateur (13) apte à produire un deuxième signal (S2) de fréquence (NF0) égale à un multiple entier de celle du premier signal (S1), en fonction d'un signal (E2) de commande ;
- des moyens (6, 9, 12) d'asservissement en phase du deuxième signal (S2) sur le premier signal (S1), produisant le signal (E2) de commande;
- des moyens (3, 17, 20) de génération du signal (Fat) d'attaque à partir du deuxième signal (S2);
**caractérisé en ce qu'**il comprend des moyens (3) de fourniture directe d'au moins un signal (Se) étalon à partir du premier signal (S1), connectés en aval du premier oscillateur (2) et en amont du deuxième oscillateur (13) et le deuxième oscillateur (13) est choisi de manière à produire un deuxième signal (S2) de fréquence égale à une valeur comprise dans une plage de 1 GHz de part et d'autre de la fréquence de résonance du résonateur (R).

2. Dispositif (1) selon la revendication 1, **caractérisé en ce que** le deuxième oscillateur (13) est choisi de manière à produire un deuxième signal (S2) de fréquence sensiblement égale à un des vingt multiples entiers (NF0) de la fréquence du premier signal (S1), les plus proches de la fréquence de résonance du résonateur (R).

3. Dispositif (1) selon l'une quelconque des revendication précédentes, **caractérisé en ce que** le deuxième oscillateur (13) est choisi de manière à produire un deuxième signal (S2) de fréquence comprise dans une plage de 50 MHz de part et d'autre de la fréquence de résonance du résonateur (R).

4. Dispositif (1) selon l'une quelconque des revendications précédentes, **caractérisé en ce que** le deuxième oscillateur (13) est choisi de manière à produire un deuxième signal (S2) de fréquence sensiblement égale à un des deux multiples entiers (NF0) de la fréquence du premier signal (S1), les plus proches de la fréquence de résonance du résonateur (R).

5. Dispositif (1) selon l'une quelconque des revendications précédentes, **caractérisé en ce que** les moyens (6, 9, 12) d'asservissement en phase comprennent un circuit (9) diviseur logique de fréquence par le multiple entier (N) du deuxième signal (S2), un circuit (6) comparateur de phase de la sortie du circuit (9) diviseur du deuxième signal (S2) et du premier signal (S1) et un circuit (12) de génération du signal de commande du deuxième oscillateur. (13) à partir du signal de sortie du circuit (6) comparateur.

6. Dispositif (1) selon l'une quelconque des revendications précédentes, **caractérisé en ce que** le deuxième oscillateur (13) est choisi de manière à produire un deuxième signal (S2) de fréquence décalée par rapport à la fréquence de résonance du résonateur (R), les moyens de génération (3, 17) comportant, en aval du deuxième oscillateur (13), un circuit (17) apte à additionner et/ou soustraire en fréquence au deuxième signal (S2) un signal (D) de décalage pour fournir le signal (Fat) d'attaque, et un circuit (20) de fourniture du signal (D) de décalage.

7. Dispositif (1) selon la revendication 6, **caractérisé en ce que** le circuit (17) additionneur et/ou soustracteur est constitué par un circuit mélangeur, par exemple à bande latérale unique.

8. Dispositif (1) selon l'une quelconque des revendications 6 et 7, **caractérisé en ce que** le circuit (20) de fourniture du signal de décalage comprend un synthétiseur de fréquence synchronisé sur le premier signal (S1).

9. Dispositif (1) selon l'une quelconque des revendications 6 à 8, **caractérisé en ce que** les moyens de génération du signal (Fat) d'attaque ne comportent, en aval du deuxième oscillateur (13), que des circuits (17) d'addition et/ou de soustraction de fréquence au deuxième signal (S2).

10. Dispositif (1) destiné à générer des signaux de fréquence étalon à partir de la réponse d'un résonateur (R) atomique au césium, selon l'une quelconque des revendications précédentes, **caractérisé en ce que** le deuxième oscillateur (13)est apte à produire un deuxième signal (S2) de 9200 MHz et le premier oscillateur (2) est apte à fournir un premier signal (S1) de 10 MHz.

11. Dispositif (1) selon l'une quelconque des revendications précédentes, **caractérisé en ce qu'**il ne comporte, comme oscillateurs, que les premier et deuxième oscillateurs (2, 13).

## Patentansprüche

1. Vorrichtung (1) zur Ausgabe eines Signals (Se) einer Referenzfrequenz ausgehend von der Antwort eines atomaren Resonators (R) auf ein Treibsignal (Fat), welches ihm geschickt wird, umfassend:
- einen ersten Oszillator (2), der geeignet ist, ein erstes Signal (S1) zu erzeugen, dessen Frequenz (F0) Funktion des Antwortsignals (E1) des Resonators (R) ist;
- einen zweiten Oszillator (13), der geeignet ist, ein zweites Signal (S2) zu erzeugen, dessen Frequenz (NFO) gleich einem ganzzahligen Vielfachen derer des ersten Signals (S1) ist, in Abhängigkeit von einem Steuersignal (E2);
- Mittel (6, 9, 12) zur Phasenregelung des zweiten Signals (S2) in Bezug auf das erste Signal (S1), welche das Steuersignal (E2) erzeugen;
- Mittel (3, 17, 20) zur Erzeugung des Treibssignals (Fat) ausgehend von dem zweiten Signal (S2);
**dadurch gekennzeichnet,**
**dass** sie Mittel (3) zur direkten Lieferung mindestens eines Referenzsignals (Se) ausgehend von dem ersten Signal (S1) umfasst, welche unterstromig von dem ersten Oszillator (2) und oberstromig von dem zweiten Oszillator (13) angeschlossen sind, und der zweite Oszillator (13) derart gewählt ist, dass er ein zweites Signal (S2) erzeugt, dessen Frequenz gleich einem Wert ist, der in einem Bereich von 1 GHz oberhalb und unterhalb der Resonanzfrequenz des Resonators (R) liegt.

2. Vorrichtung (1) nach Anspruch 1,
**dadurch gekennzeichnet,**
**dass** der zweite Oszillator (13) derart gewählt ist, dass er ein zweites Signal (S2) erzeugt, dessen Frequenz im Wesentlichen gleich einem der zwanzig ganzzahligen Vielfachen (NFO) der Frequenz des ersten Signals (S1) ist, die am nächsten an der Resonanzfrequenz des Resonators (R) liegen.

3. Vorrichtung (1) nach einem der vorstehenden Ansprüche,
**dadurch gekennzeichnet,**
**dass** der zweite Oszillator (13) derart gewählt ist, dass er ein zweites Signal (S2) erzeugt, dessen Frequenz in einem Bereich von 50 MHz oberhalb und unterhalb der Resonanzfrequenz des Resonators (R) liegt.

4. Vorrichtung (1) nach einem der vorstehenden Ansprüche,
**dadurch gekennzeichnet,**
**dass** der zweite Oszillator (13) derart gewählt ist, dass er ein zweites Signal (S2) erzeugt, dessen Frequenz im Wesentlichen gleich einem der zwei ganzzahligen Vielfachen (NFO) der Frequenz des ersten Signals (S1) ist, die am nächsten an der Resonanzfrequenz des Resonators (R) liegen.

5. Vorrichtung (1) nach einem der vorstehenden Ansprüche,
**dadurch gekennzeichnet,**
**dass** die Mittel (6, 9, 12) zur Phasenregelung eine logische Frequenzteilerschaltung (9), die die Frequenz durch das ganzzahlige Vielfache (N) des zweiten Signals (S2) teilt, eine Vergleicherschaltung (6), die die Phase des Ausgangs der Teilerschaltung (9) des zweiten Signals (S2) mit der Phase des ersten Signals (S1) vergleicht, und einen Generatorkreis (12), der ein Steuersignal des zweiten Oszillators (13) ausgehend von dem Ausgangssignal des Vergleicherschaltkreises (6) erzeugt, umfasst.

6. Vorrichtung (1) nach einem der vorstehenden Ansprüche,
**dadurch gekennzeichnet,**
**dass** der zweite Oszillator (13) derart gewählt ist, dass er ein zweites Signal (S2) mit einer in Bezug auf die Resonanzfrequenz des Resonators (R) verschobenen Frequenz erzeugt, wobei die erzeugenden Mittel (3, 17) unterstromig von dem zweiten Oszillator (13) einen Schaltkreis (17) umfassen, der geeignet ist, der Frequenz des zweiten Signals (S2) eine Frequenz eines Verschiebungssignals (D) hinzuzufügen bzw. sie von ihr abzuziehen, um ein Treibssignal (Fat) zu erzeugen, und einen Schaltkreis (20) zur Ausgabe des Verschiebungssignals (D).

7. Vorrichtung (1) nach Anspruch 6,
**dadurch gekennzeichnet,**
**dass** der Addier- und/oder Subtrahierschaltkreis (17) von einem Mischschaltkreis gebildet ist, beispielsweise mit Einseitenband.

8. Vorrichtung (1) nach einem der Ansprüche 6 oder 7,
**dadurch gekennzeichnet,**
**dass** der Schaltkreis (20) zur Ausgabe des Verschiebungssignals einen Frequenzsynthesizer umfasst, der auf das erste Signal (S1) synchronisiert ist.

9. Vorrichtung (1) nach einem der Ansprüche 6 bis 8,
**dadurch gekennzeichnet,**
**dass** die Mittel zur Erzeugung des Treibssignals (Fat) unterstromig von dem zweiten Oszillator (13) nur Schaltkreise (17) umfassen, die eine Frequenz zu dem zweiten Signal (S2) addieren und/oder von ihm subtrahieren.

10. Vorrichtung (1), welche dazu bestimmt ist, ausgehend von der Antwort eines atomaren Cäsium-Resonators (R) Signale einer Referenzfrequenz zu erzeugen, nach einem der vorstehenden Ansprüche,
**dadurch gekennzeichnet,**
**dass** der zweite Oszillator (13)geeignet ist, ein zweites Signal (S2) von 9200 MHz zu erzeugen, und der erste Oszillator (2) geeignet ist, ein erstes Signal (S1) von 10 MHz zu erzeugen.

11. Vorrichtung (1) nach einem der vorstehenden Ansprüche,
**dadurch gekennzeichnet,**
**dass** sie als Oszillatoren nur den ersten und den zweiten Oszillator (2, 13) umfasst.

## Claims

1. Device (1) for supplying a standard frequency signal (Se) from the response of an atomic resonator (R) to a drive signal (Fat) which is sent to it, comprising:
- a first oscillator (2) suitable for producing a first signal (S1) of frequency (F0) as a function of the answering signal (E1) from the resonator (R);
- a second oscillator (13) suitable for producing a second signal (S2) of frequency (NF0) equal to a whole multiple of that of the first signal (S1), as a function of a control signal (E2);
- means (6, 9, 12) of in-phase servo assistance of the second signal (S2) on the first signal (S1), producing the control signal (E2);
- means (3, 17, 20) of generating the drive signal (Fat) from the second signal (S2);
**characterised in that** it includes means (3) for direct supply of at least one standard signal (Se) from the first signal (S1), connected downstream of the first oscillator (2) and upstream of the second oscillator (13), and the second oscillator (13) is selected so as to produce a second signal (S2) of frequency equal to a figure included within a range of 1 GHz on either side of the resonance frequency of the resonator (R).

2. Device (1) according to Claim 1, **characterised in that** the second oscillator (13) is selected so as to produce a second signal (S2) of frequency more or less equal to one of the twenty whole multiples (NF0) of the frequency of the first signal (S1), those closest to the resonance frequency of the resonator (R).

3. Device (1) according to any one of the above claims, **characterised in that** the second oscillator (13) is selected so as to produce a second signal (S2) of frequency included within a range of 50 MHz on either side of the resonance frequency of the resonator (R)

4. Device (1) according to any one of the above claims, **characterised in that** the second oscillator (13) is selected so as to produce a second signal (S2) of frequency more or less equal to one of the two whole multiples (NF0) of the frequency of the first signal (S1), those closest to the resonance frequency of the resonator (R)

5. Device (1) according to any one of the above claims, **characterised in that** the in-phase servo assistance means (6, 9, 12) include a frequency logic divider circuit (9) through the whole multiple (N) of the second signal (S2), a phase comparator circuit (6) of the output of the divider circuit (9) of the second signal (S2) and of the first signal (S1) and a circuit (12) generating the control signal of the second oscillator (13) from the output signal of the comparator circuit (6).

6. Device (1) according to any one of the above claims, **characterised in that** the second oscillator (13) is selected so as to produce a second signal (S2) of frequency offset in comparison with the resonance frequency of the resonator (R), the generating means (3, 17) comprising, downstream of the second oscillator (13), a circuit (17) suitable for adding and/or subtracting as frequency at the second signal (S2) a shift signal (D) to supply the drive signal (Fat), and a circuit (20) for supplying the shift signal (D).

7. Device (1) according to Claim 6, **characterised in that** the adding and/or subtracting circuit (17) consists of a mixer circuit, for example with single lateral band.

8. Device (1) according to any one of the Claims 6 and 7, **characterised in that** the circuit (20) supplying the shift signal includes a frequency synthesizer synchronised on the first signal (S1).

9. Device (1) according to any one of the Claims 6 to 8, **characterised in that** the means of generating the drive signal (Fat) only comprise, downstream of the second oscillator (13), frequency addition and/or subtraction circuits (17) at the second signal (S2).

10. Device (1) designed to generate standard frequency signals from the answering of a caesium atomic resonator (R), according to any one of the above claims, **characterised in that** the second oscillator (13) is suitable for producing a second signal (S2) of 9200 MHz and the first oscillator (2) is suitable for supplying a first signal (S1) of 10 MHz.

11. Device (1) according to any one of the above claims, **characterised in that** it only comprises, as oscillators, the first and second oscillators (2, 13).
